# EUROPÄISCHE PATENTSCHRIFT

(11) **EP 1 012 980 B1**
(45) Veröffentlichungstag und Bekanntmachung des Hinweises auf die Patenterteilung: **06.03.2002**
(21) Anmeldenummer: 98940178.1
(22) Anmeldetag: 08.07.1998
(51) Int. Cl.: H03L 7/099, H03K 23/68

(54) **DIGITALER PHASE LOCKED LOOP**
DIGITAL PHASE LOCKED LOOP
BOUCLE NUMERIQUE A PHASE ASSERVIE

(30) Priorität: 10.07.1997 DE 19729477; 10.07.1997 DE 19729476
(43) Veröffentlichungstag der Anmeldung: 28.06.2000
(73) Patentinhaber: Nokia Networks Oy, 02150 Espoo (FI)
(72) Erfinder: POUTANEN, Antti, FIN-00140 Helsinki (FI); SUVITAIVAL, Pekka, FIN-01590 Maisala (FI)
(74) Vertreter: Schippan, Ralph, Dr.-Ing.
(86) Internationale Anmeldenummer: EP9804235
(87) Internationale Veröffentlichungsnummer: WO9903207

(56) Entgegenhaltungen:
- EP-A- 0 471 506
- EP-A- 0 644 657
- DE-A- 1 921 133
- US-A- 5 335 253
- YOSHINORI ROKUGO ET AL: "A DIGITAL PHASE-LOCKED LOOP FOR STUFFING SYNCHRONIZATION SYSTEMS" ELECTRONICS & COMMUNICATIONS IN JAPAN, PART I - COMMUNICATIONS, Bd. 75, Nr. 4, 1. April 1992, Seiten 1-12, XP000307927 NEW YORK US

## Beschreibung

Die Erfindung betrifft einen digitalen Phase Locked Loop zur Synchronisation eines Ausgangstaktsignals (output clock) mit einem Referenztaktsignal (reference clock) bestehend aus einem numerisch gesteuerten Oszillator, der die Frequenz eines ihm zugeordneten lokalen Oszillators teilt und als Ergebnis das Ausgangstaktsignal liefert, wobei der numerisch gesteuerte Oszillator hinsichtlich seines gewünschten, insbesondere einer Bruchzahl entspechenden Teilerwertes (Divisor) derart programmierbar ist, daß er zwischen mindestens zwei numerischen Teilerwerten umschaltbar ist, wobei der numerisch gesteuerte Oszillator mindestens zwei separat hinsichtlich ihrer Teilerwerte programmierbare und derart zueinander in Kaskadenschaltung angeordnete Teilerstufen (4a,4b,4c) aufweist, daß ein Eingangssignal einer vorgeordneten Teilerstufe durch ein Teilerstufenausqanqstaktsiqnal einer nachgeordneten Teilerstufe gebildet wird, und daß das Teilerstufenausgangstaktsignal einer vorgeordneten Teilerstufe das Taktsiqnal einer nachgeordneten Teilerstufe bildet, und aus einem Phasendetektor, dem das Referenztaktsignal (reference clock) und das rückgekoppelte Ausgangstaktsignal (output clock) zum Detektieren von deren Phasendifferenz gemeinsam zugeführt werden und an dessen Ausgang ein der Phasendifferenz entsprechendes digitales Signal erzeugbar ist, wobei die Frequenz des Ausgangstaktsignals zusätzlich entsprechend der ermittelten Phasendifferenz durch weitere Variation des Teilerwertes veränderbar ist.

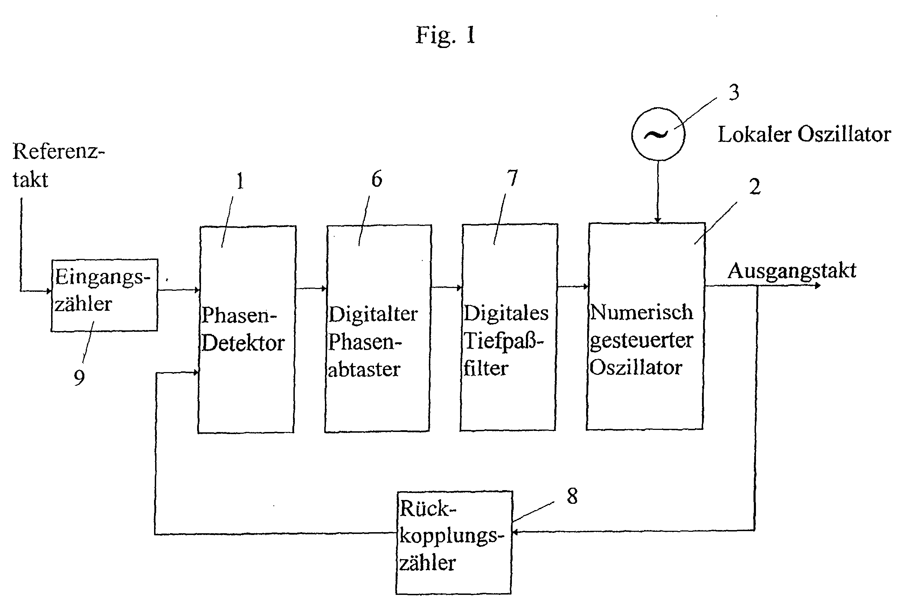

Üblicherweise entspricht der Aufbau einer digitalen Phase Locked Loop Schaltung (DPLL) derjenigen, die in Fig. 1 dargestellt ist. Dabei ist es Aufgabe des DPLL, der Phase des Eingangsreferenztaktes zu folgen, indem ein numerisch gesteuerter Oszillator verwendet wird, der die Frequenz seines lokalen Oszillators dahingehend herunterteilt, daß sich das Ausgangstaktsignal mit der gewünschten Frequenz ergibt. Wenn die Phasenlage des Ausgangstaktsignales hinter derjenigen des Referenztaktsignales herläuft, hat der Schaltkreis die Aufgabe, den numerisch gesteuerten Oszillator zu "beschleunigen". Dies wird üblicherweise dadurch erreicht, daß durch einen kleineren Zählerwert (Divisor) geteilt wird als durch denjenigen, der der Zentralfrequenz entspricht. Wenn umgekehrt die Phasenlage des Ausgangstaktsignals gegenüber dem Referenztakt voreilt, hat der Schaltkreis die Aufgabe, den numerisch gesteuerten Oszillator zu "verlangsamen", indem durch eine größere Zahl anstelle des Mittenfrequenzwertes geteilt wird.

Die Phasendifferenz zwischen dem Referenztakt und dem Ausgangstakt wird üblicherweise durch einen Phasendetektor ermittelt und hieraus das der Phasendifferenz entsprechende digitale Eingangssignal für den numerisch gesteuerten Oszillator gewonnen. In einer praktischen Realisation erfolgt dies durch einen Phasenabtaster, welcher ein digitales Wort entsprechend der jeweiligen gemessenen Phasendifferenz erzeugt. Verschiedene Phasenabtastwerte werden durch ein digitales Tiefpaßfilter gefiltert, um die gewünschte Übertragungsfunktionseigenschaften des DPLL zu erreichen.

Eine Digitale Phase Locked Loop (DPLL) Schaltung der eingangs genannten Art ist aus der EP 0 471 506 A2 bekannt. Hierbei handelt es sich um eine Synchronisationsschaltung, bei der die Frequenz des lokalen Oszillators um ein nicht-ganzzahliges Vielfaches heruntergeteilt wird und wobei das Ausgangssignal mit dieser Frequenz ausgegeben wird. Hierzu wird ein programmierbarer Teiler verwendet. Dieser enthält eine Teilersteuerung (divide control), die einen Teilerwert zur Verfügung stellt, den der numerisch gesteuerte Oszillator zum Teilen der Frequenz des lokalen Oszillators verwendet. Die Teilersteuerung generiert zwei verschiedene Teilerwerte, um so eine Bruchzahlteilung der Oszillatorfrequenz durchführen zu können. Die gewünschte Zentralfrequenz des DPLL Ausgangstaktsignals wird durch Umschalten zwischen den beiden Teilerwerten eingestellt. Um dabei die Amplitude des Phasensynchronisationsfehlers ("Jitter") möglichst gering zu halten, erfolgt das Zuschalten der Teilerwerte einerseits möglichst häufig und andererseits so gleichmäßig wie möglich. Zusätzlich zum Umschalten zwischen den Teilerwerten in dem durch die gewünschte Ausgangsfrequenz vorgegebenen Muster erfolgt eine Steuerung des Teilers abhängig von der erfaßten Phasendifferenz, derart daß eine additive oder substraktive Größe zu dem von der Teilersteuerung vorgegebenen Teilerwert addiert wird. D.h. zusätzlich wird der aktuelle Teilerwert je nach Phasendifferenz zwischen dem erzeugten Signal und dem Referenztaktsignal eventuell in der Divisoreinheit erhöht bzw. erniedrigt. Wird nun eine additive Größe entsprechend der Phasendifferenz zu dem Teilerwert addiert, wenn diesem aktuell der höhere der zwei vorgesehenen Werte zugeordnet ist, so ergibt sich eine größerer Abstand zwischen zwei aufeinanderfolgenden ausgegebenen Impulsen, als dies nur durch das Umschalten zwischen zwei Teilerwerten auftreten kann. Entsprechend ist der Abstand kleiner, wenn aufgrund der Phasendifferenz eine subtraktive Größe zu dem kleineren der zwei Teilerwerte addiert wird. Der größere Unterschied zwischen den Teilerwerten und damit der Impulsabstände des ausgegebenen Signals ist gleichbedeutend mit einem größeren Synchronisationsfehler (Jitter). In vielen Telekommunikationsanwendungen ist jedoch der zugelassenen Jitter-Größe eine Grenze gesetzt, die durch die oben beschriebenen Konstellationen überschritten werden kann.

Die Erzeugung des hierzu erforderlichen Software-Algorithmus und die zur Bildung der Zählerwerte erforderliche Hardware stellen einen vergleichsweise hohen Aufwand dar.

Bei Phase-Locked-Loop-Anwendungen ist die relative Bandbreite des lokalen Oszillators üblicherweise sehr schmal, beispielsweise einige 10 ppm. Die gewünschte Ausgangsfrequenz der Phase-Locked-Loop-Schaltung wird aus dem lokalen Oszillator gewonnen, indem dem Ausgangssignal einzelne Taktimpulse hinzugefügt oder abgezogen werden, entsprechend der ermittelten Phasenverschiebung zwischen dem Ausgangssignal und einem Referenzsignal. In Kurzzeitbetrachtung können diese zusätzlichen Taktimpulse als Phasensprünge betrachtet werden, während sich bei Langzeitbetrachtung dieses als ein stabiler Frequenzoffset bemerkbar macht, wenn Phasenverschiebungen mit einer festgelegten Periode erzeugt werden.

Ein numerisch gesteuerter Oszillator mit Mitteln zur Verschiebung der Phasenlage ist aus der WO 94/26033 bekannt. Bei diesem Stand der Technik enthält der numerisch gesteuerte Oszillator eine erste Oszillatoreinheit, innerhalb der ein als Frequenzteiler arbeitender Zähler angeordnet ist. Der Zähler erhält die Frequenz des lokalen Oszillators und weist darüber hinaus einen Phasenregeleingang auf. Hierdurch wird die Phase des Ausgangssignals des Zählers in der gewünschten Richtung angepaßt.

Aus US 5 335 253 ist ein nicht integraler Frequenzteiler bekannt, wobei der Frequenzteiler mindestens zwei separat hinsichtlich ihrer Teilerwerte programmierbare und derart zueinander in Kaskadenschaltung angeordnete Teilerstufen aufweist, daß ein Eingangssignal einer vorgeordneten Teilerstufe durch ein Teilerstufenausgangstaktsignal einer nachgeordneten Teilerstufe gebildet wird, und daß das Teilerstufenausgangstaktsignal einer vorgeordneten Teilerstufe das Taktsiqnal einer nachgeordneten Teilerstufe bildet. Durch die kaskadenartige Anordnung der Teilerstufen im Teiler im Frequenzteiler ist eine entsprechend einfache Anpassung an die gewünschte Synchronisiergenauigkeit gegeben ist.

Der Erfindung liegt die Aufgabe zugrunde, bei einem digitalen Phase Locked Loop der eingangs genannten Art die Genauigkeit der Synchronisation bei geringen Jitter Erscheinungen entsprechend dem jeweiligen Anwendungsfall in hardwaremäßig einfacher und kostengünstiger Weise vornehmen zu können.

Die Erfindung zeichnet sich dadurch aus, daß Mittel (SHIFT) zur Ansteuerung der Teilereinheit (DIV) vorgesehen sind, um durch Abänderung des Divisors beim Anlegen eines SHIFT-Signals die Phasenlage des Ausgangssignales in einer vorgebbaren Richtung gegenüber einem Referenzsignal zu verschieben, wobei die Mittel (SHIFT) zur Verschiebung der Phasenlage am Eingang einer in der Kaskade höchstens auf zweithöchster Stufe stehenden Teilerstufe (DIV O/P) anliegen. Dadurch ergibt sich folgender Vorteil:

Aufgrund der Rückkopplung des Ausgangssignals der nachgeordneten Teilerstufe auf den Eingang der vorgeordneten Teilerstufe besteht bei einer solchen Kaskadenschaltung grundsätzlich das Problem, daß zeitgleich mit dem Eingangstaktsignal an den anderen Eingang der Teilerstufe das Taktsignal zur Verschiebung der Phasenlage (SHIFT-Control) anliegen kann. Hierdurch kann es am Ausgang des Teilers zu einem doppelt so großem Phasensprung kommen. Die erfindungsgemäße Lösung sieht nun vor, daß das SHIFT-Control-Signal nicht an der obersten Teilerstufe des kaskadenförmigen Teilers angreift, so daß dort ein doppelter Phasensprung vermieden wird. Dies hat zur Folge, daß das Ausgangssignal der obersten Teilerstufe nicht durch unzulässig hohe Jitter-Erscheinungen nachteilig beeinflußt wird. Vielmehr erfolgt die Abgabe des SHIFT-Signals gemäß der Erfindung auf eine der nachgeordneten Teilerstufen, so daß sich der durch das SHIFT-Signal hervorgerufene Phasensprung nicht mehr auf das Teilerverhältnis des ersten Teilers auswirkt sondern lediglich dessen Datensequenz beeinflußt. Um dennoch einen merklichen Einfluß auf die Phasenlage des Ausgangssignals der ersten Teilerstufe zu erreichen, muß die Häufigkeit des SHIFT-Signals entsprechend nach oben angepaßt werden.

Die Erfindung wird im folgenden anhand einer Zeichnung näher erläutert.

Dabei zeigen
- Fig. 1: ein Ausführungsbeispiel für eine Digitale Phase Locked Loop Schaltung (DPLL), wie sie aus dem Stand der Technik bekannt ist
- Fig. 2: ein erstes Ausführungsbeispiel einer Digitalen Phase Locked Loop Schaltung
- Fig. 3: ein zweites Ausführungsbeispiel, dargestellt anhand des Aufbaus eines numerisch gesteuerten Oszillators für eine Digitale Phase Locked Loop Schaltung
- Fig. 4: eine Prinzip-Darstellung eines numerisch gesteuerten Oszillators gemäß Stand der Technik,
- Fig. 5: eine Veranschaulichung des auftretenden Phasenfehlers in einem numerisch gesteuerten Oszillator nach Fig. 4,
- Fig. 6a: eine Prinzip-Darstellung eines numerisch gesteuerten Oszillators enthaltend einen Bruchteiler,
- Fig. 6b: ein Blockschaltbild eines Ausführungsbeispiels für einen numerisch gesteuerten Oszillator nach Fig. 6a,
- Fig. 7: zeitliche Darstellungen zur Erläuterung der Funktionsweise der in Fig. 6 dargestellten Schaltung ohne Berücksichtigung des SHIFT-Eingangs, insbesondere zeigen
Fig. 7a eine Skizze zur Veranschaulichung des Zählerzustandes im Teiler des numerisch gesteuerten Oszillators in Abhängigkeit von der Zeit,
Fig. 7b den zeitlichen Verlauf des lokalen Oszillator-Signals,
Fig. 7c den zeitlichen Verlauf des am Ausgang des Teilers ausgegebenen Ausgangstaktsignals und
Fig. 7d das theoretische Ausgangssignal am Ausgang des numerisch gesteuerten Oszillators im idealisierten Zustand mit äquidistanten Pulsen,
- Fig. 8: zeitliche Darstellungen zur Erläuterung der Funktionsweise der in Fig. 6 dargestellten Schaltung mit Berücksichtigung des anliegenden SHIFT-Signals, insbesondere zeigen
Fig. 8a eine Skizze zur Veranschaulichung des Zählerzustandes im Teiler des numerisch gesteuerten Oszillators in Abhängigkeit von der Zeit,
Fig. 8b den zeitlichen Verlauf des lokalen Oszillator-Signals,
Fig. 8c den zeitlichen Verlauf des am Ausgang des Teilers ausgegebenen Ausgangstaktsignals und
Fig. 8d den zeitlichen Verlauf des am Ausgang des Teilers ausgegebenen Ausgangstaktsignals, jedoch mit einem zusätzlichen Puls (Pfeil) beim Auftreten des SHIFT-Eingangssignals,
Fig. 8e den zeitlichen Verlauf des am Ausgang des Teilers ausgegebenen Ausgangstaktsignals, jedoch mit einem anderen zusätzlichen Puls (Pfeil) beim Auftreten des SHIFT-Eingangssignals
Fig. 8f das theoretische Ausgangssignal am Ausgang des numerisch gesteuerten Oszillators im idealisierten Zustand mit äquidistanten Impulsen,
- Fig. 9: einen numerisch gesteuerten Oszillator gemäß der Erfindung und
- Fig. 10: zeitliche Darstellungen zur Erläuterung der Funktionsweise der in Fig. 9 dargestellten Schaltung, insbesondere zeigen
Fig. 10a eine Skizze zur Veranschaulichung des Zählerzustandes im Teiler des numerisch gesteuerten Oszillators in Abhängigkeit von der Zeit,
Fig. 10b den zeitlichen Verlauf des lokalen Oszillator-Signals,
Fig. 10c den zeitlichen Verlauf des am Ausgang des Teilers ausgegebenen Ausgangstaktsignals und
Fig. 10d das theoretische Ausgangssignal am Ausgang des numerisch gesteuerten Oszillators im idealisierten Zustand mit äquidistanten Pulsen.

Wie in Fig. 1 dargestellt ist, besteht der Grundaufbau einer an sich bekannten DPLL-(Digital Phase Locked Loop) Schaltung aus der Kettenschaltung eines Phasendetektors 1, eines digitalen Phasenabtasters 6, eines digitalen Tiefpaßfilters 7 und eines numerisch gesteuerten Oszillators 2. Der numerisch gesteuerte Oszillator 2 wird von einem lokalen Oszillator 3 mit einer vorgegebenen Frequenz angesteuert. Das Ausgangssignal am numerisch gesteuerten Oszillator 2 wird einerseits der Anwendung zugeführt und andererseits über einen Rückkopplungszähler 8 an den einen Eingang des Phasendetektors 1 rückgekoppelt. Der andere Eingang des Phasendetektors 1 wird über einen Eingangszähler 9 mit dem Referenztaktsignal versorgt.

Am Ausgang des Phasendetektors 1 wird ein der Phasendifferenz zwischen dem Referenzsignal und dem rückgekoppelten Ausgangstaktsignal entsprechendes Signal gebildet, indem digitale Abtastwerte erzeugt werden. Eine Folge digitaler Phasenabtastwerte wird über das digitale Tiefpaßfilter 7 gefiltert, so daß am Ausgang des digitalen Tiefpaßfilters 7 ein der Phasendifferenz entsprechendes digitales Wort (z.B. 8 Bitwort) vorliegt, welches an den Eingang des numerisch gesteuerten Oszillators 2 gegeben wird. Im numerisch gesteuerten Oszillator 2 wird mittels eines (nicht dargestellten) Teilers die Frequenz des lokalen Oszillators 3 auf die Zentralfrequenz des gewünschten Ausgangstaktsignals heruntergeteilt. Im Falle einer vom Phasendetektor 1 ermittelten Phasendifferenz zwischen Referenztakt und rückgekoppelten Ausgangstaktsignal wird im Teiler des numerisch gesteuerten Oszillators nicht um den der Zentralfrequenz entsprechenden Teilerwert geteilt, der dem Verhältnis aus Oszillatorfrequenz und Ausgangstaktsignalfrequenz entspricht, sondern je nach Phasenlage um einen davon abweichenden Wert.

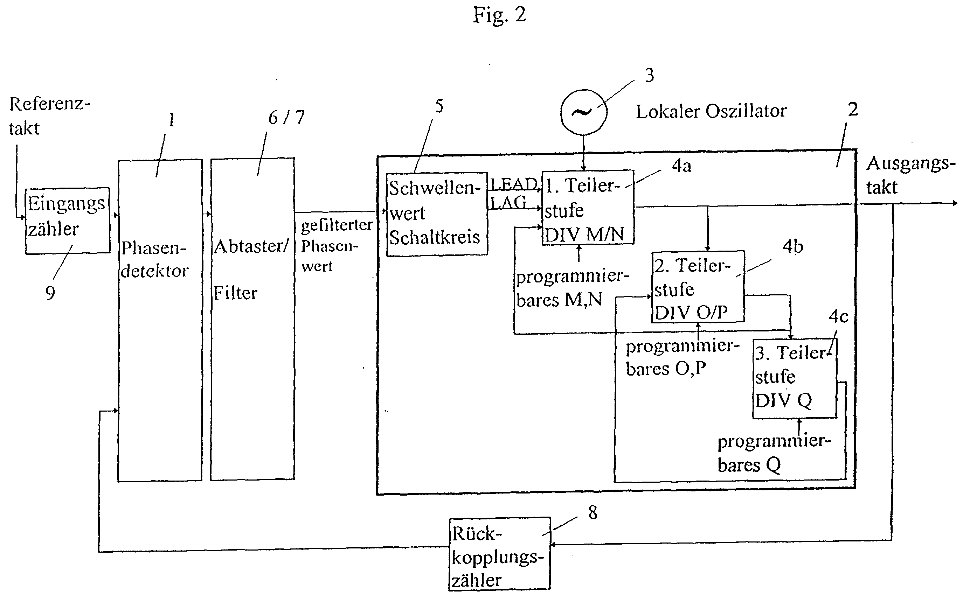

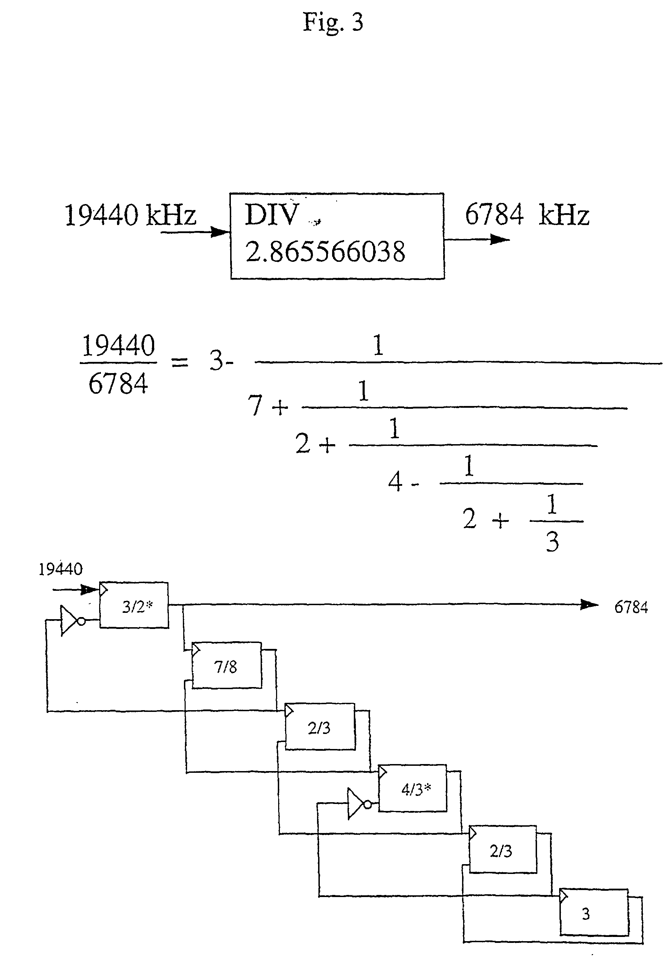

Der digitale Phase Locked Loop nach Fig. 2, 3 besteht aus der Kettenschaltung eines Phasendetektors 1, eines digitalen Phasenabtasters 6, eines digitalen Tiefpaßfilters und eines numerisch gesteuerten Oszillators 2. Der numerisch gesteuerte Oszillator 2 wird von seinem lokalen Oszillator angesteuert. Am Ausgang des numerisch gesteuerten Oszillators wird ein Ausgangstaktsignal gebildet, welches über einen Rückkopplungszähler 8 (feedback counter) an den Eingang des Phasendetektors 1 gelegt wird. Der andere Eingang des Phasendetektors 1 ist über einen Eingangszähler 9 mit dem Referenztaktsignal verbunden.

Das Ausgangssignal des Abtasters/Filters 6 gelangt auf einen Schwellenwertschaltkreis 5 (threshold circuit), welcher feststellt, ob das der Phasendifferenz entsprechende digitale Wort oberhalb oder unterhalb einer vorgebbaren Schwelle liegt. Wenn dieses Wort oberhalb einer vorgebbaren Schwelle liegt, wird am Ausgang des Schwellenwertschaltkreises 5 das Signal LEAD erzeugt. Umgekehrt ist dann, wenn das digitale Wort unterhalb eines vorgegebenen Schwellenwertes liegt, das Ausgangssignal LAG.

Beide Signale LEAD, LAG sind mit dem Eingang einer ersten Teilerstufe 4a innerhalb des numerisch gesteuerten Oszillators verbunden. Diese Teilerstufe weist zwei unterschiedliche Teilerwerte M/N auf, welche vorgebbar sind. Das Ausgangssignal der ersten Teilerstufe (DIV M/N) gelangt einerseits zur Anwendung (Ausgangstakt). Andererseits ist der Takteingang eines weiteren Teilers (DIV O/P) hiermit verbunden. Auch der zweite Teiler ist zwischen zwei Teilerwerten O,P umschaltbar. Dessen Ausgangssignal gelangt einerseits als rückgekoppeltes Signal an den Eingang des ersten Teilers (DIV M/N) und andererseits an den Takteingang eines dritten Teilers (DIV Q), dessen Teilerwert (Q) fest ist. Der Ausgang der dritten Teilerstufe DIV Q ist wiederum mit dem Eingang der zweiten Teilerstufe gekoppelt.

Die beschriebene Schaltung (drei in Kaskade geschaltete Teilerstufen 4a,4b,4c) arbeitet wie folgt:

Die erste Teilerstufe 4a DIV M/N liefert das gewünschte Ausgangstaktsignal, indem sie die Frequenz des lokalen Oszillators durch M oder N teilt. Normalerweise teilt diese Teilerstufe die Frequenz des lokalen Oszillators durch M und liefert diese heruntergeteilte Frequenz für die Anwendungen und zusätzlich als Eingangstaktsignal für die zweite Teilerstufe 4b DIV O/P. Die Teilerstufe 4b DIV O/P gibt normalerweise mit einer Frequenz, die gleich der durch O geteilten Frequenz ihres Eingangstaktsignals ist, ein Signal an die Teilerstufe 4a DIV M/N ab, woraufhin die erste Teilerstufe die Frequenz des lokalen Oszillators einmal durch N statt durch M teilt.

Das Ausgangssignal der Teilerstufe 4b DIV O/P dient außerdem als Eingangstaktsignal für die dritte Teilerstufe 4c DIV Q, die die Frequenz dieses Eingangstaktsignals durch Q teilt und mit der hierdurch festgelegten geteilten Frequenz ein Signal an die Teilerstufe 4b DIV O/P abgibt. Auf dieses Signal hin teilt die Teilerstufe 4b DIV O/P die Frequenz seines Eingangstaktsignals einmal durch P statt durch O und gibt dementsprechend zu einem anderen Zeitpunkt ein Signal an die erste Teilerstufe 4a DIV M/N ab.

Auf diese Weise ist es möglich, mit einer entsprechenden Anzahl von Teilerstufen ein beliebiges Teilerverhältnis zu erreichen, da mit einer Programmierung der Teilerwerte der verschiedenen Teilerstufen der Wechsel zwischen den beiden Teilerwerten der ersten Teilerstufe frei einstellbar ist.

Die Signale LEAD und LAG liefern zusätzliche Signale an die erste Teilerstufe 4a DIV M/N, durch die bei einer zu großen Phasendifferenz zwischen Referenztaktsignal und Ausgangstaktsignal der aktuelle durch die Programmierung der Teilerstufen in der Kaskade festgelegten Teilerwert erhöht bzw. erniedrigt wird.

Figur 3 zeigt einen numerisch gesteuerten Oszialator mit sechs in Kaskade geschalteten Teilerstufen, an dem die Berechnung der zu programmierenden Teilerwerte deutlich wird. Die Frequenz eines lokalen Oszillators von 19440 kHz soll entsprechend der Frequenz des Referenztaktsignals auf 6784 kHz heruntergeteilt werden, was einer Division durch 2.865566038 entspricht. Für eine exakte Teilung ist für dieses Beispiel eine sechsstufige Kaskadenschaltung notwendig.

Als Teilerwerte einer jeweiligen Teilerstufe werden jeweils die numerischen Zahlen, zwischen denen der benötigte Divisor liegt, vorgegeben, wobei als Hauptteilerwert diejenige Zahl verwendet wird, die der Bruchzahl näher kommt. Für die erste Teilerstufe in dem Beispiel ist 3 die numerische Zahl, die dem Wert 2.865566038 am nächsten kommt, es werden also die Teilerwerte 3 und 2 programmiert. Aus 19440/6784 erhält man somit 3-912/6784. Der verbleibende Rest wird zur Berechnung der zweiten Teilerstufe verwendet, indem der Kehrwert der Bruchzahl in den Nenner geschrieben wird (1 /6784/912) und für die Bruchzahl im Nenner wieder die nächste numerische Zahl, in diesem Fall die 7, bestimmt wird. Aus dem Nenner 6784/912 erhält man also 7+400/912 und somit die Teilerwerte 7 und 8 für die zweite Teilerstufe. Der Bruch wird wiederum so umgewandelt, daß der Kehrwert im Nenner steht, und dieser Nenner wird wieder in eine numerische Zahl und einen verbleibenden Rest aufgespalten. Auf diese Weise wird weiterverfahren, bis ein verbleibender Rest von 1/x (in diesem Fall 1/3) erhalten wird, wobei x eine numerische Zahl ist, womit ein exaktes Nachbilden des Bruches erreicht wird, oder aber bis eine gewünschte Genauigkeit gegeben ist. Der Nenner des letzten Bruchs liefert den einzigen Teilerwert für die letzte Teilerstufe, die ihre Eingangstaktsignalfrequenz immer durch den gleichen Teilerwert teilt. Vor den Teilerstufen eins und vier ist in Fig. 3 im Gegensatz zu den anderen Teilerstufen jeweils ein Inverter eingezeichnet, da die Hauptteilerzahl auf ein Signal der nächsten Stufe hin um 1 erniedrigt statt erhöht werden muß.

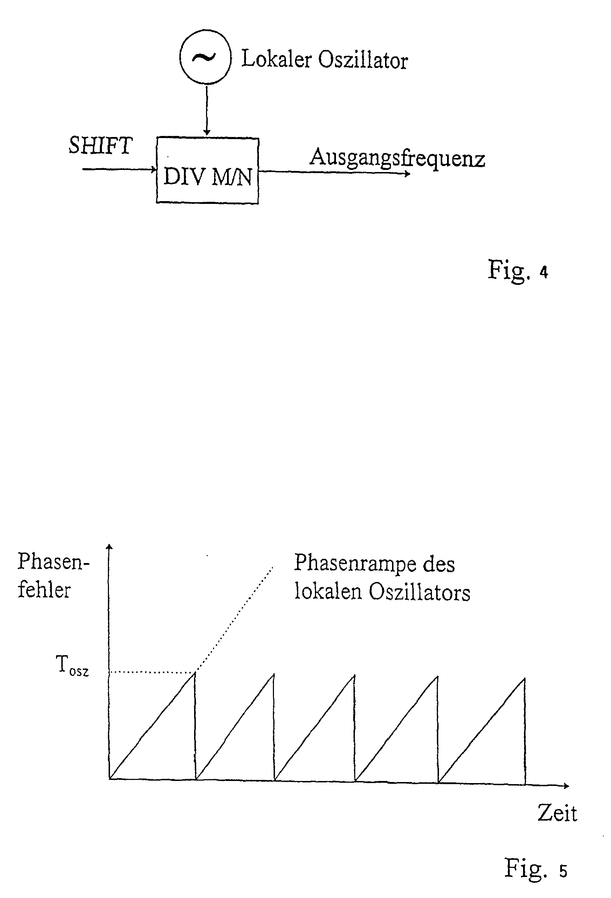

Fig. 4 zeigt den prinzipiellen Aufbau eines numerisch gesteuerten Oszillators, welcher Teil einer digitalen Phase-Locked-Loop-Schaltung zur Nachlaufsynchronisation eines Ausgangstaktsignales mit einem Referenztaktsignal ist. Die zur Vervollständigung des numerisch gesteuerten Oszillators zu einer Phase-Lock-Loop-Schaltung weiter erforderlichen Blöcke, wie ein Phasendedektor bzw. ein digitales Filter und die entsprechenden Rückkopplungszweige sind in Fig. 4 nicht dargestellt.

Der numerisch gesteuerte Oszillator enthält einen lokalen Oszillator, welcher eine sehr schmale Bandbreite aufweist. In einer Teilerstufe DIV M/N wird aus dem Frequenzsignal des lokalen Oszillators die gewünschte Ausgangsfrequenz gewonnen. Ausgangsfrequenz und Frequenz des lokalen Oszillators stehen dabei über den Divisor des Teilers in Beziehung.

Der Divisor des Teilers im numerisch gesteuerten Oszillator ist dabei alternativ zwischen einem numerischen Wert M und einem weiteren numerischen Wert N umschaltbar. Im Normalfall teilt der Teiler durch die Zahl M und dann, wenn ein SHIFT-Impuls anliegt, durch den Wert N.

Fig. 5 zeigt den zeitlichen Verlauf des Phasenfehlers, welcher bei dem beschriebenen numerisch gesteuerten Oszillator auftritt. Ausgehend vom Wert Null wächst dieser im Laufe der Zeit, solange durch denselben Divisor (z.B. M) geteilt wird. Wenn zum Zeitpunkt, bei dem ein maximal zulässiger Phasenfehler T_{OSC} erreicht wird, auf den anderen Divisor N durch Anlegen des SHIFT-Signales umgeschaltet wird, sinkt der Phasenfehler wieder auf Null und anschließend erfolgt wiederum ein entsprechender Anstieg. Der theoretische Verlauf des Phasenfehlers (ohne Umschalten des Divisors von M auf N) ist in Form der ansteigenden gestrichelten Linie dargestellt.

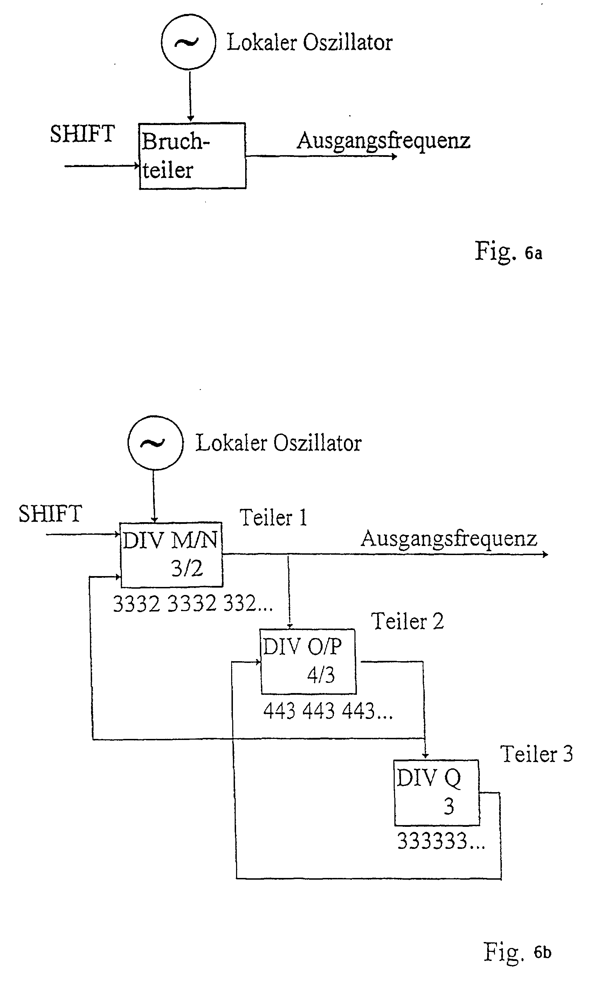

Fig. 6a zeigt eine aus dem Stand der Technik der EP 0 471 506 prinzipiell bekannte Schaltung, bei der die Ausgangsfrequenz aus der Frequenz des lokalen Oszillators über einen sogenannten Bruchteilsteiler (fractional divider) heruntergeteilt gewonnen wird.

In einer Realisierung dieses bekannten fractional dividers, wie sie in Fig. 6b dargestellt ist, besteht der Teiler aus drei einzelnen Teilerstufen DIV M/N, DIV O/P und DIV Q, wobei die beiden ersten Teilerstufen jeweils zwischen zwei numerischen Werten M/N bzw. O/P umschaltbar sind und die dritte Teilerstufe einen festen numerischen Teilerwert Q aufweist. Jeder Teiler hat ein Rückkopplungssignal, welches den Zähler dahingehend steuert, jeweils einen Taktimpuls mehr oder weniger entsprechend dem gewünschten Teilerverhältnis zu zählen. Durch diese Struktur wird somit ein Teilerwert in Form einer rationalen Zahl simuliert. Der Rückkopplungseingang des Teilers 1 erzeugt jeweils einen Phasensprung am Ausgangssignal. Auch der SHIFT-Control-Eingang des Zählers 1 verursacht einen Phasensprung in gleicher Größe, nämlich eine Oszillator-Periode.

Wenn am Teilereingang DIV M/N gleichzeitig das Rückkopplungssignal und ein SHIFT-Control-Impuls auftreten, wird der Phasensprung hierdurch verdoppelt. Da in vielen Telekommunikationsanwendungen die lokale Oszillatorfrequenz so niedrig wie möglich gewählt wird, kann unter Umständen der einfache Phasensprung bereits bemerkbar werden, jedenfalls aber der doppelte Phasensprung zu nicht akzeptablen Betriebsbedingungen führen.

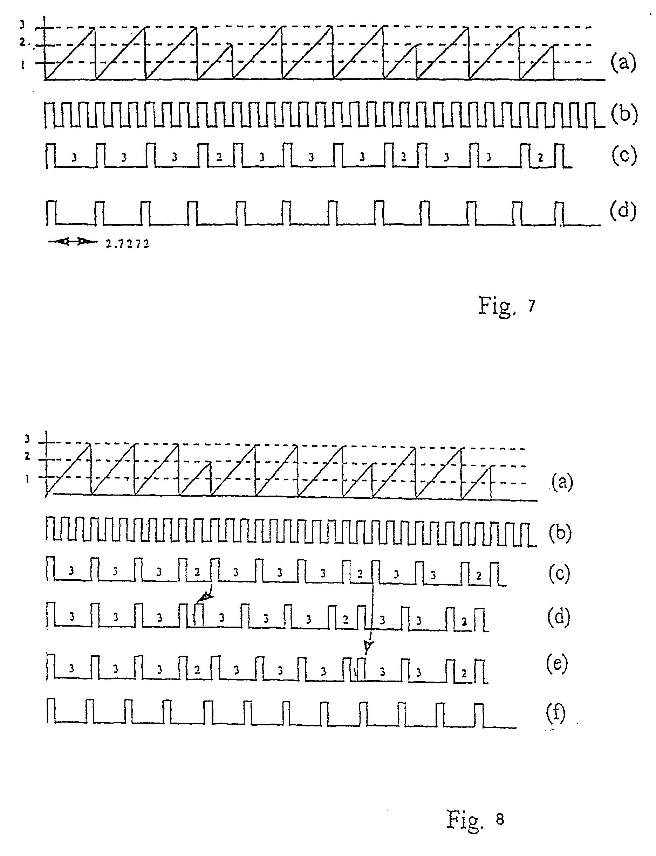

Die oben beschriebenen Effekte werden anhand der Figuren 7 und 8 näher erläutert:

In Fig. 7a ist der Zustand des dem Teiler im numerisch gesteuerten Oszillator zugeordneten Zählers in Abhängigkeit von der Zeit dargestellt, d.h. er kann im Laufe der Zeit die Werte 1, 2, 3 oder 0 annehmen, je nachdem wie viele Taktsignale des lokalen Oszillators (Pulszug gemäß Fig. 7b) vom Eingangszähler gezählt worden sind. Durch den eingestellten Teilerwert 3 wird jeder dritte Impuls des lokalen Oszillators durchgelassen (Fig. 7c). Infolge des Teilerwertes 4 der zweiten Stufe (DIV O/P) wird vor Eintreffen des vierten Impulszuges der Teiler 1 vom Wert M = 3 auf N= 2 umgeschaltet, so daß nur ein Impuls des lokalen Oszillators ausgelassen wird. Anschließend erfolgt wiederum der beschriebene Vorgang mit der Pulsfolge 3332 3332 ... solange, bis der Zählerwert des dritten Zählers DIV Q maßgeblich wird.

Auf diese Weise ergeben sich wechselnde Perioden von 3 bzw. 2 Impulsen Dauer. Im Langzeitbereich (idealisiert) betrachtet ergibt sich somit eine Impulsfolge mit äquidistanten Impulsen, wie sie in Fig. 7d dargestellt ist ensprechend einer gewünschten Ausgangsfrequenz mit dem Teilerverhältnis 2,7272.

Die oben beschriebenen Ausführungen ergeben sich ohne Berücksichtigung des SHIFT-Signals.

Unter Berücksichtigung des SHIFT-Signals (Darstellung gemäß Fig. 8) ergeben sich insoweit Unterschiede, als angenommen wird, daß für einen ersten betrachteten Fall (Fig. 8d) nach Ablauf der 333-Pulsfolge gleichzeitig mit der Änderung des Teilerverhältnisses von 3 auf 2 ein SHIFT-Impuls (Pfeil) an den Eingang des Teilers angelegt wird, wodurch sich der vierte Zyklus auf einen Impuls mit der Zykluslänge 1 verkürzt statt der in Fig. 8c vorgegebenen Zykluslänge 2.

Ein anderes Beispiel ist in Fig. 8e dargestellt, wo zu einer anderen Zeit (Pfeil) der SHIFT-Impuls erfolgt, so daß auch dort das ursprünglich zwei Impulse lange Signal auf eine Zykluslänge von 1 herabgesetzt wird.

Durch die zusätzlich auftretenden SHIFT-Impule ergeben sich größere Phasensprünge und somit ein zusätzlicher Jitter, welcher in vielen Anwendungen nicht akzeptabel ist.

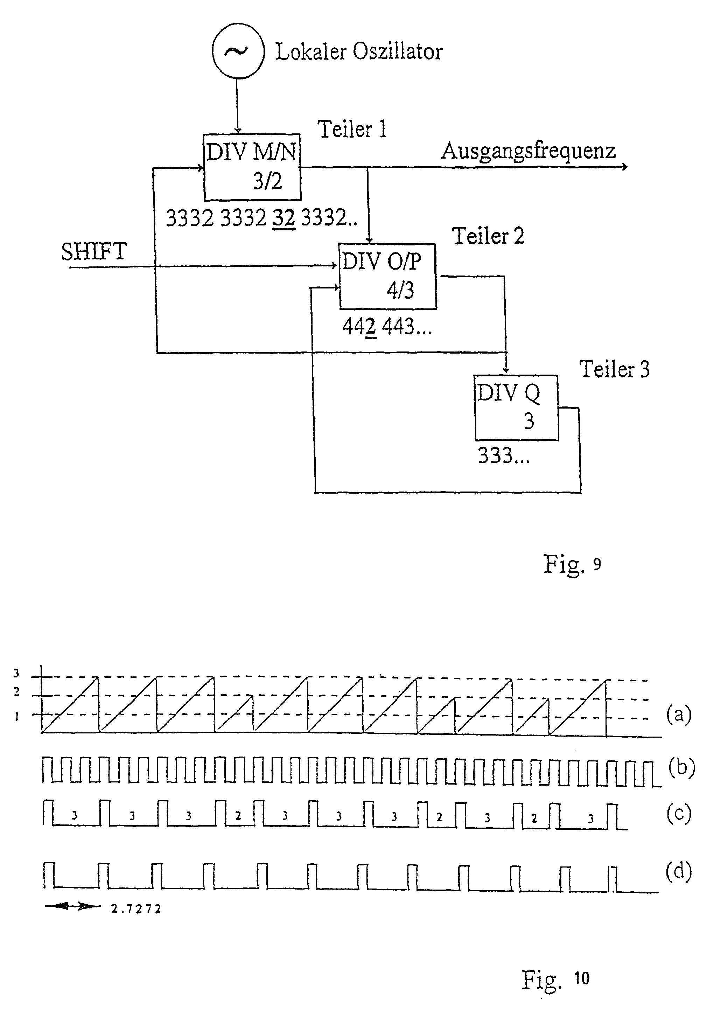

Fig. 9 zeigt die erfindungsqemäße Lösung eines numerisch gesteuerten Oszillators.

Im Unterschied zu Fig. 6b ist gemäß Fig. 9 das SHIFT-Impuls-Signal nicht an den in der Teilerstufenkaskade am höchsten angeordneten Teiler DIV M/N sondern an den Eingang des zweithöchsten Teilers DIV O/P angelegt. Im übrigen unterscheidet sich die in Fig. 9 dargestellte Schaltung weder im Aufbau noch in ihrer Funktionsweise von derjenigen, wie sie in Fig. 6b dargestellt wurde und anhand der Figuren 7 und 8 mit und ohne SHIFT-Signal erläutert wurde.

Der Einfluß des SHIFT-Signales erstreckt sich nunmehr auf den zweiten Teiler DIV O/P, wodurch vermieden wird, daß das SHIFT-Signal direkt an den Eingang des ersten Teilers gelangt und hierdurch der nachteilige doppelte Phasensprungeffekt auftritt.

Allerdings ist der Einfluß des SHIFT-Signales hierdurch geringer als bei dem in Fig. 6 dargestellten Beispiel, so daß die Häufigkeit des SHIFT-Signals im Vergleich zu dem am Teiler 1 angreifenden SHIFT-Signal entsprechend erhöht werden muß.

Gemäß Fig. 9 beeinflußt das SHIFT-Signal zwar die Sequenz des Teilers 1 jedoch nicht sein Teilerverhältnis, wodurch ein zusätzlicher Jitter beim Auftreten der SHIFT-Modulation vermieden wird. Vielmehr ist das Teilerverhältnis im Teiler 1 stets 3 oder 2.

Die entsprechenden Impulszüge sind in den Figuren 10c bzw. im idealisierten Fall 10d dargestellt.

Die erste Teilerstufe weist im Normalfall das Teilerverhältnis 3 auf und wechselt dann auf den anderen Teilerwert 2, wenn die zweite Teilerstufe mit dem Normalteilerwert 4 entsprechend hochgezählt hat.

Hierdurch ergibt sich im Teiler 1 die Grundsequenz 3332 3332 3332 .... Eine übergeordnete Korrektur dieser Sequenz erfolgt über die Teilerstufe 3, deren Teilerwert als 3 fest vorgegeben ist.

Im folgenden soll der Fall betrachtet werden, daß zu dem mit dem Pfeil betrachteten Zeitpunkt ein SHIFT-Impuls an den Eingang der zweiten Teilerstufe gegeben wird. Dieser Zeitpunkt ist identisch mit demjenigen Zeitpunkt, zu dem die zweite Teilerstufe 2 ohnehin auf den anderen Teilerwert (3 statt 4) umschaltet. Durch diesen doppelten Eingangsimpuls ergibt sich somit eine Verkürzung der Datensequenz von vier auf zwei Impulse (Sequenz **32** unterhalb der ersten Teilerstufe dargestellt).

Wenngleich sich die Datensequenz der ersten Teilerstufe hierdurch ändert, wird die Größe des Phasensprungs hiedurch nicht beeinflußt, da stets nur einer der beiden Teilerwerte 3 oder 2 in der ersten Teilerstufe auftritt. Hierdurch kommt es also nicht zur Beeinflussung der Hochfrequenz-Jitters.

Aufgrund der verwendeten VLSI-Technologie ist die lokale Oszillatorfrequenz üblicherweise beschränkt. Das bedeutet, daß der minimal erreichte Jitter ebenfalls durch die VLSI-Technologie beschränkt ist. Durch Verwendung des numerisch gesteuerten Oszillators gemäß der Erfindung ist es also möglich, solche numerischen Oszillatoren zu verwenden, die zum einen auf der Bruchteilsstruktur (fractional structure) beruhen und andererseits den erzeugten Jitter auf maximal die Hälfte üblicher Werte begrenzen, wenn die lokale Oszillatorfrequenz fest ist bzw. die lokale Oszillatorfrequenz zu halbieren, wenn der maximal zulässige Jitter festgelegt ist.

## Patentansprüche

1. Digitaler Phase Locked Loop zur Synchronisation eines Ausgangstaktsignals mit einem Referenztaktsignal bestehend aus einem numerisch gesteuerten Oszillator (2), der die Frequenz eines ihm zugeordneten lokalen Oszillators (3) teilt und als Ergebnis das Ausgangstaktsignal liefert, wobei der numerisch gesteuerte Oszillator (2) hinsichtlich seines gewünschten, insbesondere einer Bruchzahl entspechenden Teilerwertes derart programmierbar ist, daß er zwischen mindestens zwei numerischen Teilerwerten umschaltbar ist, wobei der numerisch gesteuerte Oszillator mindestens zwei separat hinsichtlich ihrer Teilerwerte programmierbare und derart zueinander in Kaskadenschaltung angeordnete Teilerstufen (4a,4b,4c) aufweist, daß ein Eingangssignal einer vorgeordneten Teilerstufe durch ein Teilerstufenausgangstaktsignal einer nachgeordneten Teilerstufe gebildet wird, und daß das Teilerstufenausgangstaktsignal einer vorgeordneten Teilerstufe das Taktsignal einer nachgeordneten Teilerstufe bildet, und aus einem Phasendetektor (1), dem das Referenztaktsignal und das rückgekoppelte Ausgangstaktsignal zum Detektieren von deren Phasendifferenz gemeinsam zugeführt werden und an dessen Ausgang ein der Phasendifferenz entsprechendes digitales Signal erzeugbar ist, wobei die Frequenz des Ausgangstaktsignals zusätzlich entsprechend der ermittelten Phasendifferenz durch weitere Variation des Teilerwertes veränderbar ist
**dadurch gekennzeichnet, daß** Mittel zur Ansteuerung der Teilerstufe vorgesehen sind, um durch Abänderung des Teilerwertes der Teilerstufe beim Anlegen eines SHIFT-Signals die Phasenlage des Ausgangssignales in einer vorgebbaren Richtung gegenüber dem Referenzsignal zu verschieben, wobei die Mittel zur Verschiebung der Phasenlage am Eingang einer in der Kaskade höchstens auf zweithöchster Stufe stehenden Teilerstufe anliegen.

2. Digitaler Phase-Locked-Loop-Schaltkreis nach Anspruch 1,
**dadurch gekennzeichnet, daß** die Mittel zur Verschiebung der Phasenlage auf die zweithöchste Teilerstufe einwirken.

## Claims

1. A digital phase locked loop for synchronization of an output clock signal with a reference clock signal, comprising a numerically controlled oscillator (2), which divides the frequency of the local oscillator (3) assigned to it and provides the output signal as a result, with the numerically controlled oscillator (2) being programmable in regard to its desired divisor, which particularly corresponds to a fraction, in such a way that it can be switched between at least two numeric divisors, with the numerically controlled oscillator having at least two dividing stages (4a, 4b, 4c) which can be programmed separately in regard to their divisors and which are located in a cascade circuit relative to one another in such a way that an input signal of an upstream dividing stage is formed by a dividing stage output clock signal of a downstream dividing stage, and the dividing stage output clock signal of the upstream dividing stage forms the clock signal of a downstream dividing stage, and a phase detector (1) to which the reference clock signal and the fed back output clock signal are fed jointly to detect their phase difference and at whose output a digital signal corresponding to the phase difference can be generated, with the frequency of the output clock signal additionally able to be changed corresponding to the phase difference established by further variation of the divisor, **characterized in that** means for driving the dividing stages are provided in order to displace the phase position of the output signal in a presettable direction relative to the reference signal by changing the divisor of the dividing stage when a SHIFT signal is applied, with the means for displacement of the phase position being applied to the input of a dividing stage at at most the second-highest stage in the cascade.

2. A digital phase locked loop circuit according to claim 1, **characterized in that** the means for displacement of the phase position act on the second-highest dividing stage.

## Revendications

1. Boucle à phase asservie numérique pour synchroniser un signal d'horloge de sortie avec un signal d'horloge de référence, constituée d'un oscillateur à commande numérique (2), qui divise la fréquence d'un oscillateur local (3) qui lui est associé et qui délivre comme résultat le signal d'horloge de sortie, l'oscillateur à commande numérique (2) étant programmable en ce qui concerne sa valeur de diviseur souhaitée correspondant en particulier à un nombre fractionnaire, de sorte qu'il est commutable entre au moins deux valeurs de diviseur numériques, l'oscillateur à commande numérique présentant au moins deux étages diviseurs (4a, 4b, 4c) programmables séparément en ce qui concerne leurs valeurs de diviseur, et disposés l'un par rapport à l'autre dans un circuit en cascade, de sorte qu'un signal d'entrée d'un étage diviseur placé en amont est formé par un signal d'horloge de sortie d'étage diviseur d'un étage diviseur disposé en aval, et que le signal d'horloge de sortie d'étage diviseur d'un étage diviseur disposé en amont forme le signal d'horloge d'un étage diviseur disposé en aval, et d'un détecteur de phase (1), auquel le signal d'horloge de référence et le signal d'horloge de sortie réinjecté à l'entrée sont appliqués ensemble pour détecter leur différence de phase et à la sortie duquel un signal numérique peut être créé correspondant à la différence de phases, la fréquence du signal d'horloge de sortie étant en plus modifiable, d'une manière correspondante à la différence de phase déterminée, par une variation supplémentaire de la valeur de diviseur, **caractérisée en ce que** des moyens sont prévus pour piloter l'étage diviseur afin de décaler la position de phase du signal de sortie dans un sens pouvant être prédéterminé par rapport au signal de référence, en modifiant la valeur de diviseur de l'étage diviseur en appliquant un signal SHIFT, les moyens pour décaler la position de phase étant appliqués à l'entrée d'un étage diviseur se trouvant au plus au deuxième niveau en hauteur dans la cascade.

2. Circuit numérique de boucle à phase asservie selon la revendication 1, **caractérisé en ce que** les moyens pour décaler la position de phase agissent sur le deuxième étage diviseur en hauteur.
